# DEMANDE DE BREVET EUROPEEN

(11) **EP 1 088 785 A1**
(43) Date de publication de la demande: **04.04.2001**
(21) Numéro de dépôt: 99117852.6
(22) Date de dépôt: 10.09.1999
(51) Int. Cl.: B81B 3/00, B81C 1/00, G02B 26/08

(54) **Procédé de fabrication d'une microstructure intégrée suspendue tridimensionnelle, microstructure intégrée notamment obtenue par ce procédé et élément optique intégré réglable**

(71) Demandeur: ECOLE POLYTECHNIQUE FEDERALE DE LAUSANNE, 1015 Lausanne (CH)
(72) Inventeur: Gerhard, Lammel, 1700 Lausanne (CH)
(74) Mandataire: Ravenel, Thierry Gérard Louis

(57) **Abrégé**

L'invention concerne un procédé pour la fabrication d'une microstructure suspendue comprenant les étapes suivantes:
- former une couche de masquage sur une surface supérieure d'un substrat;
- structurer la couche de masquage pour former au moins une ouverture définissant sensiblement la surface de ladite microstructure et pour découvrir une partie du substrat correspondant à cette surface;
- porosifier électrochimiquement ledit matériau semi-conducteur découvert sur une épaisseur déterminée;
- électropolir le matériau semi-conducteur sous-jacent à ladite microstructure porosifiée pour former une cavité entourant au moins partiellement cette microstructure en dessous du niveau de la couche de masquage; et
- libérer ladite microstructure porosifiée pour former la microstructure suspendue audit substrat par au moins une portion de connexion de son périmètre pour conférer à cette microstructure une mobilité en dehors au plan du substrat.

## Description

La présente invention concerne généralement les procédés de fabrication de microstructures intégrées à partir d'un substrat en matériau semi-conducteur par les techniques de micro-usinage.

Plus particulièrement l'invention concerne un procédé de fabrication de microstructures suspendues mobiles actionnables à partir de silicium monocristallin, notamment par les techniques de porosification du silicium et d'électropolissage.

L'invention concerne également une microstructure intégrée comportant un élément suspendu en silicium poreux.

L'invention concerne également un élément optique réglable, en particulier un filtre optique diélectrique qui peut être utilisé par exemple dans des spectrophotomètres. Ces spectrophotomètres sont utilisés par exemple pour la colorimétrie, la détection de gaz et l'analyse des liquides par spectrométrie infrarouge.

La fabrication de microstructures mécaniques telles que des capteurs de pression, des accéléromètres, des micro-activateurs, des micro-pompes, etc. par les techniques de masquage et de gravage du silicium est bien connue. Ces microstructures présentent généralement des géométries tridimensionnelles complexes, par exemple comportant des éléments de structure suspendus. La fabrication de ces éléments nécessite généralement la mise en oeuvre d'un grand nombre d'étapes, notamment de dépôts et d'éliminations successifs de couches sacrificielles qui font intervenir de nombreux de niveaux de masques, ce qui rend la fabrication de ces microstructures complexe, longue et coûteuse.

On sait par ailleurs que le silicium monocristallin peut être porosifié par gravage électrochimique anodique dans une solution d'acide fluorhydrique en utilisant une faible densité de courant et que ce mécanisme permet d'éliminer complètement le silicium avec des densités de courant élevées. Cette technique d'élimination du silicium est généralement désignée par "électropolissage du silicium". Cette propriété du silicium s'est révélée intéressante dans le domaine du micro-usinage du silicium et a permis de simplifier les procédés de fabrication de microstructures suspendues en diminuant le nombre de masques et de couches sacrificielles mis en oeuvre.

Un tel procédé est décrit par exemple dans la publication intitulée "Electrochemical Fabrication of Multiwalled Micro Channels" de R.W. Tjerkstra et al, pages 133-136 des "Proceedings of Micro Total Analysis Systems 98 Workshop", Banff, Canada, dans le cadre de la fabrication de microcanaux coaxiaux dont les parois de séparation sont réalisées en silicium poreux. Selon cette publication, on forme une couche de nitrure de silicium (Si3N4) sur une face d'un substrat en silicium. On structure ensuite cette couche de Si3N4 pour former une rangée d'ouvertures régulièrement espacées et laissant apparaître le silicium sous-jacent. Le substrat ainsi formé est soumis à un électrogravage qui consiste à l'introduire dans une solution d'électrolyte et à faire circuler successivement des densités de courant élevées et faibles, entre deux électrodes plongées dans la solution. Compte tenu de l'élimination isotrope du silicium lors de la circulation de densités de courant élevées, ce procédé permet d'obtenir des canaux coaxiaux semi-cylindriques dont les parois de séparation en silicium poreux, formées avec les faibles densité de courant, sont suspendues à la couche de Si3N4. Le procédé décrit dans ce document présente toutefois l'inconvénient d'être limité à la fabrication de microstructures statiques.

La publication intitulée "Fabrication of free standing structure using single steps electrochemical etching in hydrofluoric acid" de H. Ohji et al. pages 95 à 100, Sensors and Actuators 73 (1999) propose un procédé de fabrication de poutres suspendues mobiles, notamment pour réaliser des dispositifs d'accéléromètres par les techniques d'électropolissage du silicium. Ce procédé utilise la combinaison successive des modes de gravage anisotrope et isotrope de silicium monocristallin dopé n. Selon ce procédé, on dépose une couche de nitrure de silicium (Si3N4) sur une face du substrat. On structure ensuite cette couche de Si3N4 pour former un réseau d'ouvertures allongées qui se rejoignent à une extrémité et à travers lesquelles apparaît le silicium sous-jacent. Le substrat recouvert de la couche de Si3N4 structurée est soumis à une gravure chimique initiale dans une solution d'hydroxyde de potassium pour graver le silicium découvert et former des amorces de tranchées à section transversale en forme de V. On procède ensuite à un gravage électrochimique anisotrope du silicium dans une solution électrolytique contenant du HF sous illumination pour former des tranchées à section transversale rectangulaire. Une fois que la profondeur désirée est atteinte, la densité de courant circulant dans la solution est augmentée, ce qui fait passer le dispositif dans un mode de gravage isotrope et permet l'élargissement de la base des tranchées jusqu'à ce que les tranchées adjacentes se rejoignent par dessous et libèrent les poutres. Ces poutres ainsi libérées forment une structure passive suspendue qui est mobile dans un plan parallèle au substrat. On note donc que la formation de silicium nanoporeux n'est recherchée à aucun moment dans le procédé décrit dans cette publication et est même évitée dans la mesure où la formation du silicium poreux au cours du procédé viendrait endommager les surfaces verticales des tranchées.

Selon une variante de réalisation de ce procédé, les ouvertures du masque Si3N4 forment un réseau matriciel, afin de réaliser des blocs ou plaques suspendus. Les éléments obtenus présentent toutefois un réseau de perforations.

Bien que nécessitant un faible nombre de masques, ce procédé présente toutefois plusieurs inconvénients. En effet, ce procédé est limité à la fabrication de structures mobiles passives, c'est-à-dire de structures qui ne sont pas actionnables par des moyens de commande. Par ailleurs ce procédé ne permet que de fabriquer des structures planes perforées, ce qui limite considérablement son champ d'application, notamment pour des applications optiques pour lesquelles il est généralement important de disposer de plaques présentant des surfaces exemptes de trous. Un autre inconvénient consiste en ce que ce procédé ne permet pas de réaliser des structures planes mobiles en hors du plan au substrat.

Il subsiste donc un besoin pour un procédé de fabrication qui permet la réalisation de microstructures suspendues mobiles actionnables et qui peuvent être redressées en dehors d'un plan du substrat.

La présente invention a pour but principal de remédier aux inconvénients de l'art antérieur susmentionné en fournissant un procédé simple et peu coûteux pour la fabrication de telles microstructures suspendues mobiles.

A cet effet, l'invention a pour objet un procédé pour la fabrication d'une microstructure suspendue mobile de forme générale plane ou incurvée, à partir d'un substrat en matériau semi-conducteur, ledit substrat présentant une surface supérieure sensiblement plane, caractérisé en ce qu'il comprend les étapes suivantes:
- former une couche de masquage sur ladite surface supérieure;
- structurer ladite couche de masquage pour former au moins une ouverture définissant sensiblement l'étendue de la microstructure plane désirée et pour découvrir une partie du substrat correspondant à cette étendue;
- porosifier électrochimiquement ledit matériau semi-conducteur découvert sur une épaisseur correspondant sensiblement à l'épaisseur de ladite microstructure plane à suspendre;
- électropolir le matériau semi-conducteur sous-jacent à ladite microstructure porosifiée pour former une cavité entourant au moins partiellement cette microstructure en dessous du niveau de la couche de masquage; et
- libérer ladite microstructure porosifiée pour former une structure tridimensionnelle suspendue audit substrat par au moins une portion de connexion de son périmètre et conférer à cette microstructure une mobilité en dehors du plan du substrat.

Ce procédé permet, avec un minimum d'étapes de procédé, de réaliser des microstructures suspendues intégrées tridimensionnelles pouvant se redresser en dehors du plan du substrat à partir duquel la structure est formée.

Selon un mode de réalisation préféré, le procédé comprend les étapes supplémentaires consistant à :
- déposer une couche de métallisation et
- structurer ladite couche de métallisation pour former des moyens d'activation de ladite microstructure.

La structure obtenue forme avantageusement un bilame qui peut être activé par exemple électriquement pour mouvoir la microstructure mobile autour de sa position de repos.

Selon un aspect avantageux du procédé de l'invention, l'étape de porosification est réalisée avec un profil de courant qui permet de créer un profil de porosité déterminé selon la direction de l'épaisseur de la microstructure suspendue.

En effet, selon le profil de porosité choisi, la structure suspendue peut former de façon simple et économique des éléments optiques réglables tels que des miroirs de Bragg du type réflecteur à bande sélective ou des filtres passe-bande (filtres Fabry-Perot). L'angle que forme la structure suspendue avec le plan du substrat peut être aisément ajusté par les moyens d'activation décrits plus haut pour régler les longueurs d'ondes que les filtres ou miroirs respectivement transmettent et/ou réfléchissent.

Grâce à ces caractéristiques, le procédé de l'invention permet d'ouvrir de nouvelles d'applications dans le domaine et de la micro-optique.

Selon un autre aspect de l'invention, l'invention a pour objet une microstructure comprenant une plaque suspendue, de forme générale plane ou incurvée ladite plaque étant attachée à une structure de support par au moins un ses bords pour être mobile en dehors du plan de la structure de support, caractérisée en ce que ladite plaque est réalisée en matériau semi-conducteur poreux, oxydé ou non.

Selon encore un autre aspect de l'invention, l'invention a pour objet un élément optique, notamment un miroir ou un filtre, caractérisé en ce qu'il est formé d'une plaque suspendue de forme générale plane, ladite plaque étant attachée à une structure de support par au moins un de ses bords pour être mobile en dehors du plan de la structure de support, ladite plaque étant réalisée en matériau semi-conducteur poreux, oxydé ou non.

Selon un mode préféré de réalisation de cet élément optique, il comprend en outre des moyens d'activation pour régler l'angle d'inclinaison que forme la plaque avec le plan de ladite la structure de support.

D'autres caractéristiques et avantages de la présente invention apparaîtront dans la description suivante d'un mode de réalisation préféré, présenté à titre d'exemple non limitatif en référence aux dessins annexés, dans lesquels :
- la figure 1 montre une vue en perspective d'un filtre optique suspendu activable obtenu selon le procédé de l'invention;
- les figures 2 à 8 sont des vues en coupe selon les lignes A-A et B-B de la figure 1 montrant respectivement une première et une deuxième partie du filtre optique à différentes étapes du procédé de fabrication selon l'invention,
- les figures 9 et 10 sont des vues partielles en perspective du filtre optique de la figure 1, correspondant respectivement aux étapes illustrées au figures 7 et 8,
- la figure 11 est une vue en plan du filtre optique de la figure 1 correspondant à l'étape de procédé illustrée à la figure 5.
- la figure 12 est une vue de dessus d'un autre mode réalisation d'un filtre optique suspendu obtenu selon le procédé de l'invention; et

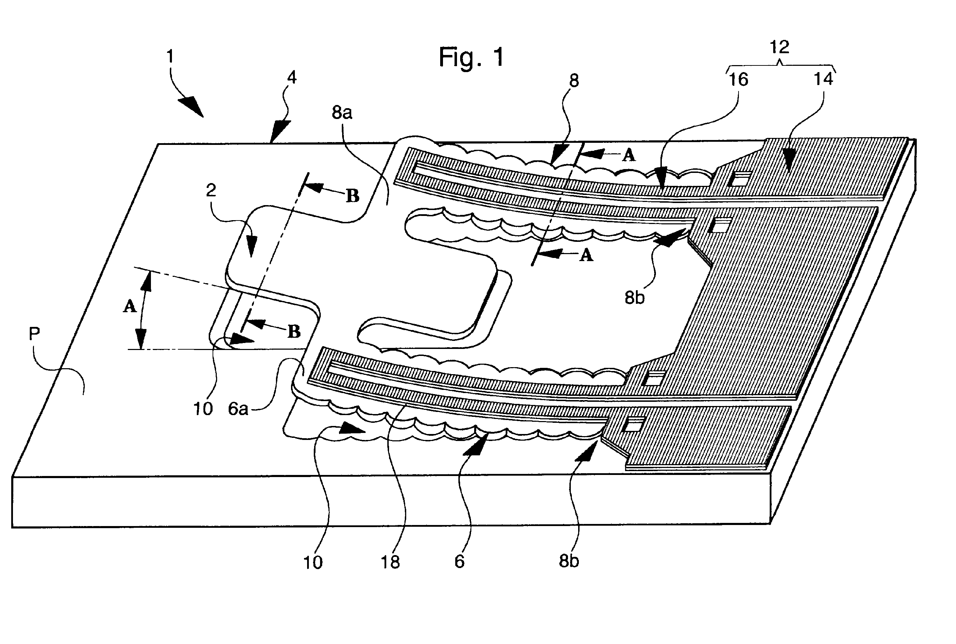

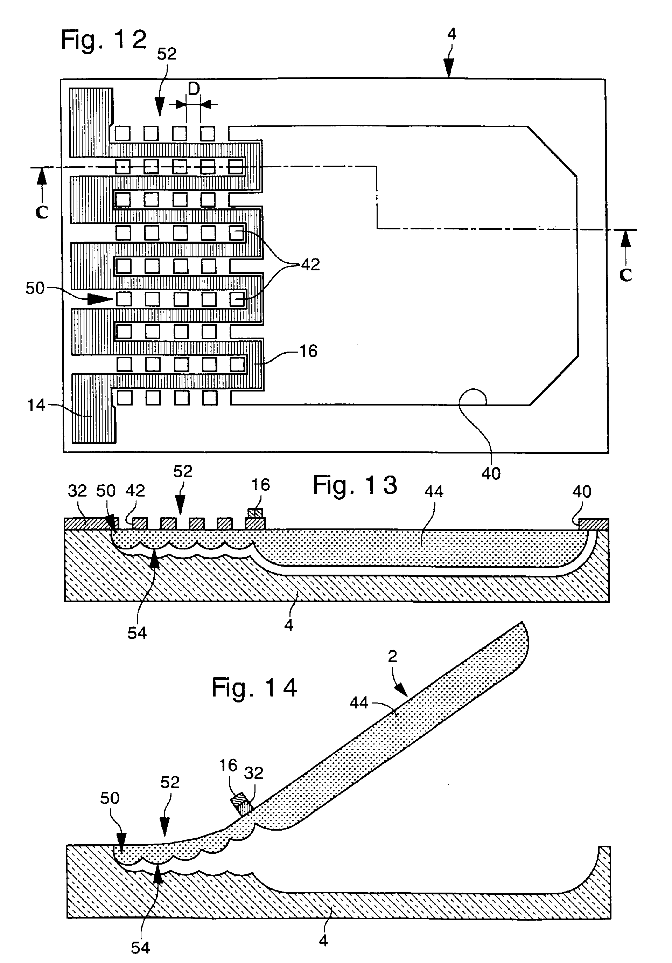

- les figures 1 et 14 sont des vues en coupes selon la ligne C-C de la figure 12 montrant respectivement le filtre optique à différentes étapes du procédé de fabrication selon l'invention.

La description du procédé de fabrication d'une microstructure intégrée suspendue tridimensionnelle mobile en dehors du plan de sa structure de support va être faite dans le cadre d'une application à la fabrication d'un élément optique réglable de forme générale plane, tel qu'un filtre passe-bande ou un réflecteur à bande sélective, dont l'inclinaison par rapport au plan de la structure de support peut être ajustée pour régler les longueurs d'ondes que le réflecteur ou le filtre respectivement transmettent et/ou réfléchissent. Bien entendu, un tel procédé peut trouver de nombreuses autres application intéressantes, par exemple pour réaliser des volets orientables, micromanipulateurs, etc.

En se référant à la figure 1, on voit une vue en perspective du filtre optique intégré orientable, désigné généralement par la référence numérique 1. Le filtre 1 comprend une plaque 2 de forme générale plane et rectangulaire suspendue à une structure de support ou substrat 4.

Dans le mode de réalisation illustré la plaque 2 est suspendue par une paire de bras parallèles 6, 8 de façon à être mobile en dehors du plan P de la structure de support. Une première extrémité 6a, 8a des bras est attachée respectivement à deux cotés opposés de la plaque 2, tandis que leur autre extrémité 6b, 8b est attachée à la structure de support 4 dans une région de bord.

La plaque 2 et les bras 6, 8 s'étendent au-dessus d'une cavité 10 creusée dans la structure de support 4 et, à l'état de repos, la plaque 2 forme un angle d'inclinaison A avec la surface supérieure P de la structure de support 4. On notera à ce propos que l'angle A dépend essentiellement de la longueur et de l'épaisseur des bras 6 et 8 ainsi que des matériaux en présence dans ces derniers. Dans l'exemple représenté l'angle A est de l'ordre de 20°, mais cet angle peut dans d'autres configurations atteindre des valeurs bien supérieures dépassant notamment les 90°.

Selon l'invention, les parties suspendues de cette microstructure, c'est-à-dire la plaque 2 et les bras 6 et 8, sont réalisés en un matériau semi-conducteur poreux, par exemple en silicium poreux par le procédé selon l'invention qui sera décrit en détail ci-après. Dans le cadre de l'application décrite, la porosité de la plaque 2 selon la direction de son épaisseur est réalisée selon un profil déterminé adapté à la nature du filtre souhaité.

Le filtre optique 1 selon l'invention comprend en outre des moyens d'activation 12 pour régler l'angle d'inclinaison A autour de sa position de repos et former ainsi un filtre orientable. Les moyens d'activation 12 comprennent une couche de métallisation formant d'une part des plages de contact 14 et d'autre part des pistes conductrices 16 reliées entre elles. Les plages de contact 14 sont ménagées, de préférence, à l'extérieur du contour des éléments suspendus, par exemple sur la surface de la structure de support 4, tandis que les pistes conductrices 16 empiètent partiellement au-dessus de portions suspendues de la structure. Dans l'exemple représenté les pistes conductrices 16 s'étendent selon un tracé sinueux au dessus des bras 6 et 8, quasiment sur toute leur longueur. Ces pistes sont typiquement réalisées en or mais peuvent être réalisées en tout matériau électriquement conducteur. De préférence, le matériau formant les plages de contact 14 et les pistes conductrices 16 sera choisi parmi l'ensemble comprenant l'or, le platine, le cuivre et le nickel.

On voit également à la figure 1 qu'une couche intermédiaire 18 s'étend sous toute la surface des plages de contact 14 et des pistes conductrices 16. La couche 18 résulte d'un mode de réalisation particulier du procédé de fabrication de l'invention qui va être décrit ci-après et n'a aucune fonction particulière dans le fonctionnement du filtre 1.

Les bras 6 et 8 avec la couche de métallisation et le cas échéant la couche intermédiaire 18 sus-jacente forment, en raison de leur différence de coefficient de dilatation thermique, un bilame qui, sous l'influence de la température, engendre une incurvation des bras 6 et 8 et provoque un déplacement correspondant de la plaque 2. En conséquence, il est possible d'orienter la plaque 2 par rapport au plan P en faisant circuler un courant dans les pistes conductrices 16. L'amplitude de déplacement de la plaque 2 dépend essentiellement du courant circulant dans les pistes 16 ainsi que de la longueur sur laquelle les pistes 16 empiètent sur les parties suspendues de la structure, les bras 6 et 8 dans l'exemple représenté. A titre indicatif, la plaque 2 peut être actionnée en appliquant des tensions de l'ordre de 5 volts sur les plages de connexion. On notera que cette activation peut conduire la plaque à la résonance mécanique, c'est-à-dire à osciller à partir de sa position de repos. Selon la géométrie de la microstructure suspendue, la fréquence de résonance peut typiquement varier entre 100 et 3000 Hz et à l'état résonnant l'amplitude de variation de la position angulaire de la plaque 2 peut atteindre les 30°.

Il va de soi pour l'homme de métier que la microstructure suspendue qui vient d'être décrite peut subir diverses modifications sans sortir du cadre de la présente invention. A titre d'exemple la plaque 2 peut être suspendue à la structure de support 4 par une portion de son bord périphérique, les pistes conductrices 16 s'étendant alors, de façon sinueuse, le long de ladite portion de bord en question, tout en empiétant sur une zone de bord suspendue de la plaque 2. La plaque 2 peut également être incurvée. On notera également qu'il est possible de prévoir plusieurs pistes conductrices qui peuvent être activées de façon indépendantes, par exemple pour tordre la plaque 2.

Il est à noter que les dessins ne représentent pas les dimensions relatives exactes des différentes éléments par rapport aux autres, certaines dimensions ayant été fortement exagérées pour plus de clarté. Pour fixer les idées, l'épaisseur de la plaque 2 est de l'ordre de 30 µm, sa surface est de l'ordre de 0, 5 mm² et la longueur des bras de l'ordre de 500 µm. L'angle A peut varier entre 0° et 180°.

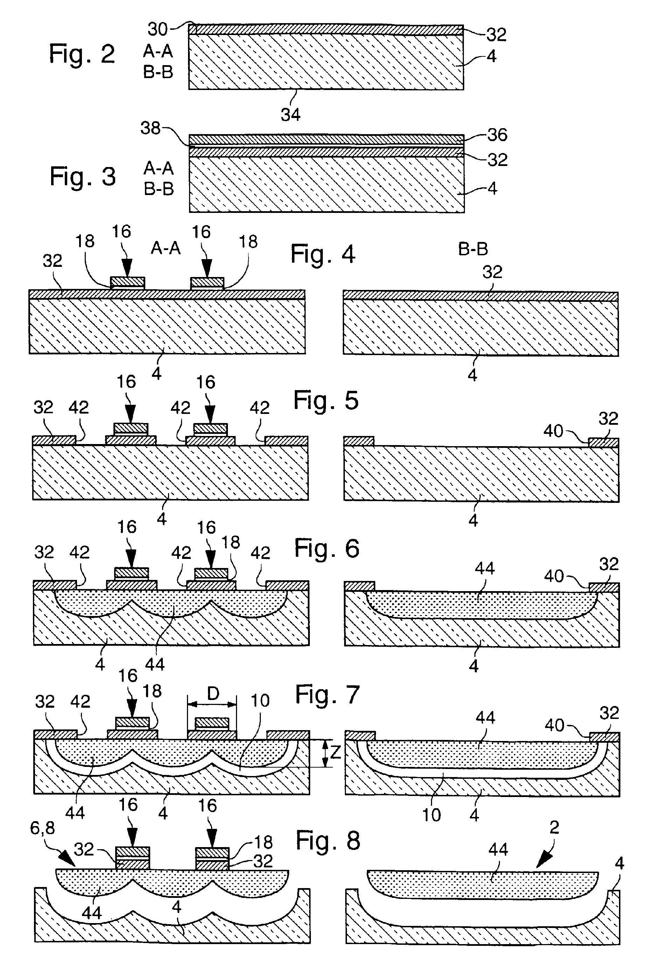

On va maintenant décrire en liaison avec les figures 2 à 11 les étapes successives du procédé de fabrication selon l'invention en vue d'obtenir le filtre optique 1 intégré décrit plus haut.

On notera tout d'abord que, compte tenu des faibles dimensions des microstructures en question et pour des raisons pratiques que l'on comprend aisément, le procédé de fabrication selon l'invention s'applique à la fabrication simultanée d'un grand nombre de filtres optiques orientables, sur une même plaquette qui définit le substrat ou la structure de support 4. Aussi, pour des raisons de simplification, la description et les figures ne porteront que sur un filtre optique.

Par ailleurs, il est important de noter que les valeurs des différents paramètres tels que les températures, les temps, les courants, les réactifs utilisés, etc. qui seront mentionnées ci-après ne sont nullement limitatives et dépendent essentiellement des matériaux et des appareillages utilisés. Ces valeurs peuvent être aisément déterminées par l'homme de métier.

Les plaquettes (non représentées) définissant le substrat à partir duquel les filtres optiques sont fabriquées sont en un matériau semi-conducteur, typiquement en silicium monocristallin dopé p.

A la figure 2, on a représenté le substrat 4 préalablement poli sur au moins sa face supérieure 30, sur laquelle on a déposé sur toute sa surface une couche 32 qui servira de masque ou de couche de masquage pour des étapes ultérieures de porosification et d'électropolissage du substrat 4. On utilisera de préférence du nitrure de silicium (Si3N4) pour réaliser la couche 32 dans la mesure où le Si3N4 résiste bien à l'acide fluorhydrique (HF) avec lequel les étapes de porosification et d'électropolissage seront réalisées.

Dans l'exemple décrit, la couche 32 a été déposée par un procédé de dépôt chimique en phase vapeur (CVD) sur une épaisseur d'environ 200nm sur les deux faces du substrat, puis le Si3N4 déposé sur la face inférieure 34 a été éliminé, par exemple par une attaque à sec avec du SF6.

L'étape suivante représentée à la figure 3 consiste à déposer une couche 36 de métallisation sur toute la surface de la couche 32. Cette couche est par exemple déposée par évaporation sous vide. Pour réaliser l'adhésion de la couche de métallisation 36 sur la couche de Si3N4, on a préalablement déposé classiquement une couche d'adhésion 38 dont la nature dépend bien entendu de celle de la couche de métallisation 36.

Dans l'exemple décrit, la couche de métallisation 36 est une couche d'or (Au) et la couche d'adhésion 38 est une couche de Nickel-Chrome (Ni-Cr). Typiquement les couches 38 et 36 sont déposées respectivement sur des épaisseurs de 10nm et 800nm.

Le métal choisi pour former la couche de métallisation 36 fait partie avantageusement de l'ensemble comprenant l'or, le platine, le cuivre et le nickel.

A l'étape suivante illustrée à la figure 4, on procède à la structuration de la couche 36 pour former les moyens d'activation 12 de la microstructure à fabriquer, en l'occurrence de la plaque 2, déjà décrits en liaison avec la figure 1. En d'autres termes, on définit les plages de contact 14 et les pistes conductrices 16 (figure 1).

Pour ce faire on dépose une couche de photoresist (non représenté) sur la couche de métallisation 36, par exemple à la tournette, on insole le photoresist à travers un masque (également non représenté) dont l'ouverture définit le contour des plages de contact 14 et des pistes conductrices 16 souhaitées, on développe classiquement par voie humide les parties du photoresist insolées pour découvrir les parties de la couche de métallisation 36 à éliminer, on grave les parties découvertes de la couche 36, on grave les parties de la couche d'adhésion 38 ayant été découvertes par le gravage précédent, puis on élimine les parties restantes de la couche de photoresist.

Dans l'exemple décrit, l'opération de gravage de la couche d'or est réalisée dans une solution d'iodure de potassium, l'opération de gravage de la couche de NiCr est réalisée, après rinçage et séchage préalable, dans une solution d'attaque humide, par exemple une solution de Ce(NH4)2(NO)3 et de CH3COOH, et l'élimination de la couche de photoresist est réalisée de façon classique, par exemple, par un solvant. On notera à ce propos que l'on utilise avantageusement le même masque pour réaliser le gravage de la couche d'or et de NiCr.

En se référant également à la figure 1, on notera que la structuration de la couche 36 est réalisée pour qu'une partie de celle-ci, en l'occurrence les pistes conductrices 16, empiète au moins partiellement sur la surface qui formera ultérieurement à la surface de la microstructure suspendue, les bras 6 et 8 dans l'exemple décrit. De plus, on notera que la structuration sera réalisée pour que les pistes conductrices 16 (figure 1) soient reliées aux plages de contact 14 situées en dehors de la surface qui formera ultérieurement la surface de la microstructure suspendue.

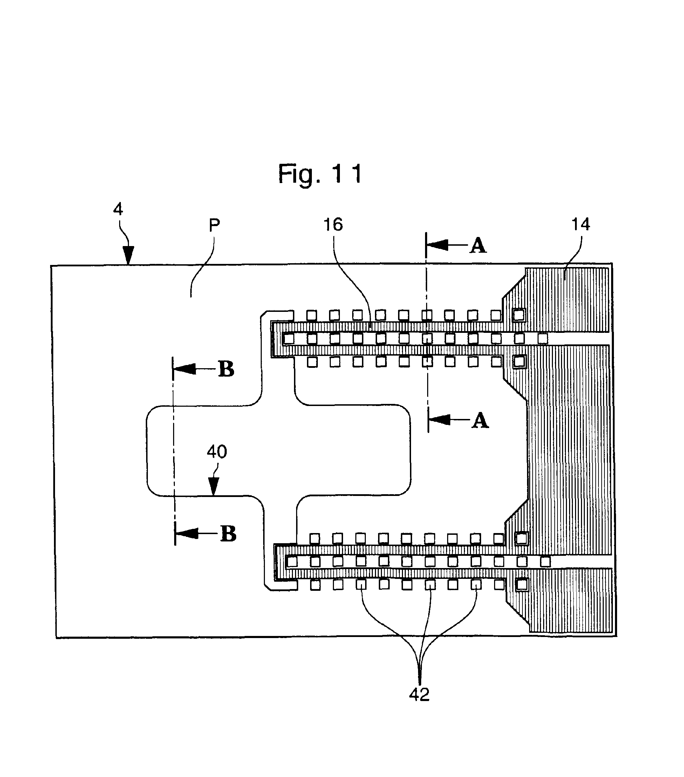

En se référant aux figures 5 et 11, on a illustré l'étape de structuration de la couche de masquage 32 pour former dans celle-ci des ouvertures 40 et 42 qui définissent ensemble sensiblement l'étendue de la microstructure suspendue désirée. Ces ouvertures 40, 42 découvrent ainsi les parties du substrat 4 correspondant à cette étendue. On notera que des ouvertures 42 sont au moins disposées autour des pistes conductrices 16. Le procédé de structuration de cette couche 32 est similaire sur le principe à celui décrit en liaison avec la figure 4. On précisera tout de même que cette structuration consiste à éliminer par une attaque à sec avec du SF6 la couche de masquage 32 aux endroits non protégés par la couche de photoresist préalablement insolée à travers un masque de forme appropriée pour réaliser les ouvertures 40 et 42. Au cours de cette étape, les parties couvertes de la couche 36 structurée sont protégées, c'est-à-dire les pistes conductrices 16 et les plages de contact 14.

L'étape suivante illustrée à la figure 6 consiste à porosifier électrochimiquement les parties du substrat 4 découvertes à l'étape précédente, c'est-à-dire les parties apparaissant à travers les ouvertures 40 et 42. La porosification du substrat est réalisée sur une épaisseur correspondant sensiblement à l'épaisseur désirée de la plaque 2 à fabriquer.

Pour ce faire, le substrat est monté sur une structure de support puis disposé entre les électrodes, une double cellule électrochimique contenant une solution d'électrolyte contenant 50% en poids d'acide fluorhydrique et de l'éthanol dans un rapport de volume 1:1. Le substrat est alors soumis pendant quelques minutes à une polarisation anodique avec une densité de courant de l'ordre de 100mA/cm2 pour porosifier le silicium apparaissant à travers les ouvertures 40 et 42, sur l'épaisseur désirée. Le silicium porosifié est désigné par la référence 44 aux figures 6 et suivantes.

On notera à ce propos que la taille des pores, la densité des pores et l'épaisseur de la couche porosifiée dépendent de la nature du substrat 4 et des paramètres de procédé utilisés. Pour l'application considérée, la dimension des pores est de l'ordre du nanomètre et leur densité est de l'ordre de 50%. L'épaisseur de la plaque 2 est typiquement de l'ordre de 30pm.

Selon une variante du procédé, il est possible au cours de cette étape de porosification de moduler en fonction du temps la densité de courant de porosification pour définir des couches successives de porosité différentes selon la direction de l'épaisseur de la couche porosifiée. Sachant que l'indice de réfraction d'une couche de silicium poreux varie en fonction de sa porosité, cette variante présente un intérêt particulier dans le cadre de la réalisation de filtres optiques formés d'un empilement de couches d'indices de réfraction différents comme par exemple les filtres de Bragg. La technique de modulation des densités de courant pour obtenir de tels empilements de couches poreuses d'indices de réfraction différents sont déjà décrites dans les brevets DE 4,319,413 et US 5,696,629 qui sont incorporés dans la présente description par référence. On notera également à ce propos que l'on peut obtenir les plaques incurvées mentionnées plus haut en modulant la porosité de la plaque et donc en modulant de de la densité de courant au cours de l'étape de porosification.

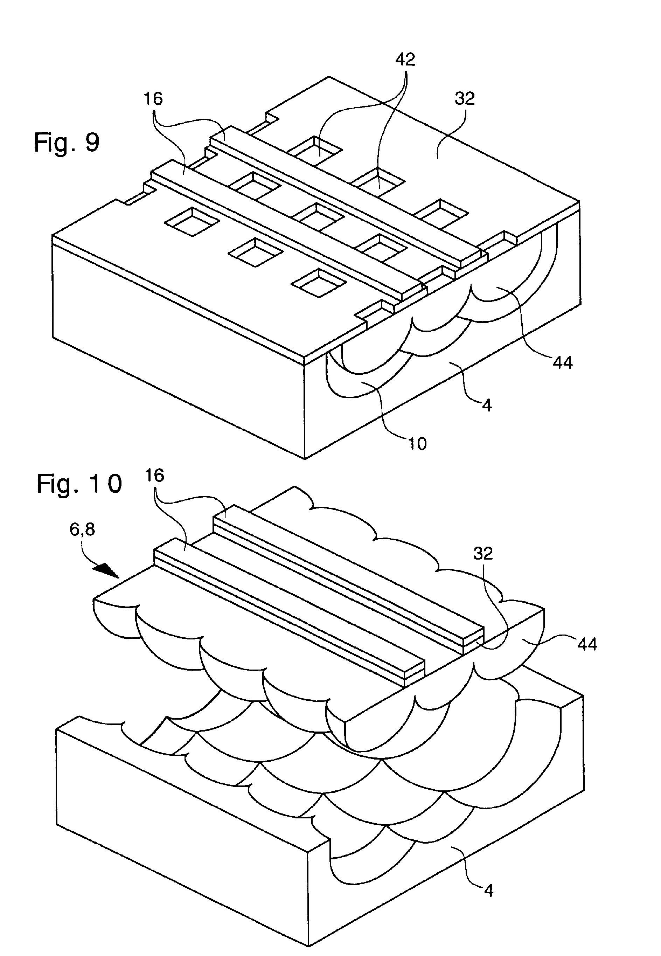

L'étape suivante illustrée par les figures 7 et 9 consiste à électropolir, c'est-à-dire éliminer électrochimiquement, le silicium sous-jacent à la couche porosifiée 44 pour former la cavité 6 qui entoure la plaque 2 et les bras 6, 8 au-dessous du niveau de la couche 32 et réaliser ainsi la structure suspendue désirée.

Pour ce faire, on conserve le même montage que celui décrit pour l'étape précédente et on ne fait qu'augmenter la densité de courant circulant dans la cellule pour passer dans le régime d'électropolissage. Dès que l'épaisseur de porosification désirée a été atteinte, le substrat est soumis à ce régime pendant un temps suffisant pour que la cavité à former autour de la structure à suspendre s'étende jusqu'en dessous de la couche de masquage 32.

On notera qu'à cette fin et compte tenu de l'isotropie des mécanismes déporosification et de l'électropolissage, il est nécessaire que les zones de silicium porosifée à travers les ouvertures 42 se rejoignent en dessous de la couche de masquage 32 pour que, lors de l'électropolissage, la cavité sous-jacente soit continue. On veillera donc, lors de l'étape de structuration de la couche 32, à ce que les ouvertures 42 soient arrangées pour que les dimensions D des portions de la couche de masquage 32 séparant deux ouvertures consécutives soit inférieures à deux fois l'épaisseur Z du silicium à porosifier, qui correspond à l'épaisseur de la plaque à fabriquer.

A l'issue de cette étape, la plaque 2 et les bras 6, 8 ne sont encore maintenus que par un pont formé par la couche de masquage 32 le long du contour respectif de la plaque 2 et des bras 6, 8 qui les relient au substrat 4 ainsi que, le cas échéant, par du silicium poreux qui n'a pas été électropoli en raison de la faible densité courant qui peut être atteinte avec une arrangement particulier des ouvertures 42 dans la couche 32 dans la zone de connexion ou suspension des bras à la structure de support.

L'étape suivante illustrée par les figures 8 et 10 consiste à libérer du substrat 4 la structure tridimensionnelle suspendue, formée de la plaque 2 et des bras 6 et 8, pour conférer à la plaque une mobilité en dehors du plan du substrat. Cette étape consiste donc à éliminer les portions de la couche de masquage 32 se trouvant le long du contour de la plaque 2 et des bras 6 , 8.

Après cette étape de libération, la plaque 2 est suspendue au substrat par l'intermédiaire des bras 6, 8 qui sont eux-mêmes en partie reliés au substrat 4 par les couches de masquage 32 et de métallisation 14, 16 qui s'étendent à la fois au-dessus des bras 6, 8 et du substrat 4. De préférence, et comme cela a été mentionné plus haut, une portion de silicium poreux se trouvant sous ces parties des 32 et 36 et ceci pour renforcer la résistance mécanique de la structure suspendue.

L'élimination de ces portions de couche 32 encore exposées est par exemple réalisée par gravage chimique. Pour ce faire, on en maintient le substrat 4 dans l'électrolyte de la double cellule électrochimique tout en inversant la polarité de la cellule par rapport à celle utilisée lors des étapes de porosification et d'électropolissage, ceci afin de protéger la structure déjà porosifiée.

Une fois cette étape de libération terminée, la structure suspendue à savoir la plaque 2 et les bras 6, 8 se redressent d'eux-mêmes en dehors du plan P du substrat 4 en raison des contraintes internes des différents matériaux formant la structure.

L'étape de libération peut être suivie d'une étape d'oxydation de la surface de la microstructure suspendue obtenue, par exemple en plaçant le substrat dans un four à environ 900°C sous une atmosphère oxydante pendant quelques heures.

Cette étape d'oxydation optionnelle, permet notamment de diminuer l'indice de réfraction de la plaque 2, d'éliminer l'absorption de la lumière visible et d'induire des contraintes supplémentaires qui tendent à augmenter l'angle A (figure 1) à l'état de repos. Par ailleurs cette étape d'oxydation permet avantageusement de prévenir le vieillissement du silicium poreux.

Le procédé qui vient d'être décrit peut bien entendu subir diverses modifications sans sortir du cadre de la présente invention. A titre d'exemple, la couche de métallisation 36 peut être déposée avant la couche de masquage 32. Dans ce cas, on veillera toutefois à structurer la couche de métallisation 36 avant le dépôt de couche de masquage. On peut également prévoir de remplacer les moyens d'actionnement thermique par des moyens d'actionnement électrostatiques. Dans ce cas, on déposera sur au moins une partie de la structure suspendue une couche conductrice formant une première armature d'un condensateur, la deuxième armature étant formée par le substrat.

On a représenté aux figures 12 à 14 le cas où la microstructure suspendue souhaitée présente la forme d'une plaque carrée ou rectangulaire 2 suspendue à la structure de support 4 par une portion d'un de ses bords 50. Dans ces figures, les éléments identiques à ceux décrits en liaison avec les figures 1 à 11 ont été désignés par les mêmes références numériques.

Dans ce mode de réalisation, la liaison de la plaque 2 au substrat 4, liaison normalement assurée par des portions de la couche de masquage 32 surmontées par les pistes conductrices 16, a été renforcée. Ceci peut être obtenu en diminuant localement la densité de courant lors de l'étape de porosification en prévoyant des ouvertures ou fenêtres 42 dans des parties de la couche de masquage 32 situées dans la zone de connexion 52 de la plaque 2 au substrat 4, qui présente ici la forme d'une bande s'étendant au dessus du bord 50 de la plaque 2. Si les ouvertures 42 dans cette zone de connexion 52 sont espacées d'une largeur D, le silicium sous-jacent se trouvant entre les ouvertures 42 sera complètement porosifié dès que la porosification latérale atteindra D/2. La densité de courant moyenne à l'interface silicium poreux/silicium massif sous une région perforée étant plus faible que dans les régions où la couche de masquage est complètement ouverte (en dehors de la zone de connexion 52), c'est-à-dire la région du masque 32 définissant l'étendue de la plaque 2, on peut choisir pour l'étape d'électropolissage une densité de courant qui, dans la région complètement ouverte, conduise à un électropolissage du silicium et qui, au niveau du bord 50, continue de porosifier le silicium pour suspendre la plaque. Cela permet ainsi de libérer la plaque 2 sur trois cotés tout en maintenant sur un coté un pont de silicium poreux 54 qui relie la plaque 2 au substrat 4, ce pont 54 se trouvant au bord de la région perforée du masque. Après l'électropolissage, la plaque 2 est encore maintenue par la couche de masquage 32 notamment à sa périphérie. La plaque 2 n'est totalement libérée pour se redresser hors du plan P du substrat 4 qu'après élimination des partie de la couche 32 encore exposées. Dans ce mode de réalisation, les pistes conductrices 16 formant les moyens d'activation présentent de préférence un tracé sinueux délimitant des zones intermédiaires dans lesquelles les ouvertures 42 sont avantageusement ménagées.

## Revendications

1. Procédé pour la fabrication d'une microstructure suspendue mobile, de forme générale plane ou incurvée à partir d'un substrat en matériau semi-conducteur, ledit substrat présentant une surface supérieure sensiblement plane, caractérisé en ce qu'il comprend les étapes suivantes:
- former une couche de masquage sur ladite surface supérieure;
- structurer ladite couche de masquage pour former au moins une ouverture définissant sensiblement la surface de la microstructure plane désirée et pour découvrir une partie du substrat correspondant à cette surface;
- porosifier électrochimiquement ledit matériau semi-conducteur découvert sur une épaisseur correspondant sensiblement à l'épaisseur de ladite microstructure plane à suspendre;
- électropolir le matériau semi-conducteur sous-jacent à ladite microstructure porosifiée pour former une cavité entourant au moins partiellement cette microstructure en dessous du niveau de la couche de masquage; et
- libérer ladite microstructure porosifiée pour former une structure tridimensionnelle suspendue audit substrat par au moins une portion de connexion de son périmètre pour conférer à cette microstructure une mobilité en dehors au plan du substrat.

2. Procédé selon la revendication 1, caractérisé en ce qu'il comprend les étapes supplémentaires consistant à :
- déposer une couche de métallisation et
- structurer ladite couche de métallisation pour former des moyens d'activation de ladite microstructure.

3. Procédé selon la revendication 2, caractérisé en ce que l'étape de structuration de la couche de métallisation est réalisée pour que cette couche empiète au moins partiellement sur ladite surface de la microstructure suspendue et pour former des plages de contact situées à l'extérieur de la surface de la microstructure suspendue et reliées à la partie de la couche de métallisation qui empiète sur la structure suspendue.

4. Procédé selon l'une des revendications 2 ou 3, caractérisé en ce que ladite couche de métallisation structurée est déposée au-dessus de ladite couche de masquage.

5. Procédé selon l'une des revendications 3 et 4, caractérisé en ce que la partie de la couche de métallisation qui empiète sur la structure suspendue présente sous la forme d'au moins une piste s'étendant sur la couche de masquage.

6. Procédé selon l'une des revendications précédentes, caractérisé en ce que l'étape de structuration de la couche de masquage comprend la formation d'une pluralité de fenêtres dans une zone adjacente à ladite portion de connexion.

7. Procédé selon les revendications 5 et 6, caractérisé en ce que les fenêtres sont arrangées autour d'au moins une partie desdites pistes.

8. Procédé selon la revendication 7, caractérisé en ce que les fenêtres sont arrangées pour que la dimension d'une portion de masque dans le plan du substrat séparant deux fenêtres consécutives soit inférieure à deux fois l'épaisseur de la microstructure porosifiée.

9. Procédé selon l'une des revendications précédentes, caractérisé en ce qu'après l'étape d'électropolissage la microstructure est retenue au moins par des portions de la couche de masquage et en ce que l'étape de libération de la microstructure consiste à éliminer les parties découvertes de ladite couche de masquage.

10. Procédé selon l'une des revendications précédentes, caractérisé en ce que l'étape d'électropolissage est réalisée à l'aide d'un courant ayant une première polarité et en ce que l'étape d'élimination du masque est réalisée chimiquement, ladite première polarité étant inversée pour protéger la structure déjà porosifiée.

11. Procédé selon l'une des revendications précédentes, caractérisé en ce qu'il comprend après l'étape de libération une étape supplémentaire d'oxydation du semi-conducteur poreux.

12. Procédé selon l'une des revendications précédentes, caractérisée en ce que l'étape de porosification est réalisée avec un profil de courant permettant de créer un profil de porosité déterminé selon la direction de gravage de la microstructure suspendue.

13. Microstructure, notamment obtenue par le procédé selon l'une des revendications 1 à 12, comprenant une plaque suspendue, de forme plane ou incurvée, ladite plaque étant attachée à une structure de support par au moins un ses bords pour être mobile selon une direction perpendiculaire au plan de la structure de support, caractérisée en ce que ladite plaque est réalisée en matériau semi-conducteur poreux, oxydé ou non.

14. Microstructure selon la revendication 13, caractérisée en ce que ladite plaque comprend un profil de porosité déterminé selon la direction de son l'épaisseur.

15. Microstructure selon l'une des revendications 13 ou 14, caractérisée en ce qu'elle comprend en outre des moyens d'activation de ladite plaque.

16. Microstructure selon la revendication 5, caractérisée en ce que lesdits moyens d'activation comprennent des pistes conductrices en métal comprenant des plages de contact situées à l'extérieur de la plaque et reliées à des pistes conductrices qui s'étendent partiellement sur la plaque.

17. Microstructure selon la revendication 13 à 16, caractérisée en ce que la plaque est suspendue à la structure de support par au moins un bras reliant la plaque par un coté ou par une portion de son bord périphérique.

18. Elément optique, notamment un miroir ou un filtre, caractérisé en ce qu'il est formé d'une plaque suspendue de forme générale plane ou incurvée, ladite plaque étant attachée à une structure de support par au moins un de ses bords pour être mobile en dehors du plan de la structure de support, ladite plaque étant réalisée en matériau semi-conducteur poreux, oxydé ou non.

19. Elément optique selon la revendication 18, caractérisé en ce qu'il comprend en outre des moyens d'activation pour régler l'angle d'inclinaison que forme la plaque avec le plan de ladite structure de support.

20. Elément optique selon la revendication 18 ou 19, caractérisé en ce que ladite plaque présente un profil de porosité correspondant à un profil d'indices de réfraction déterminé selon la direction perpendiculaire à la plaque pour réaliser un filtre optique diélectrique.
